# EUROPÄISCHE PATENTANMELDUNG

(11) **EP 4 507 199 A1**
(43) Veröffentlichungstag der Anmeldung: **12.02.2025**
(21) Anmeldenummer: 24189089.6
(22) Anmeldetag: 17.07.2024
(51) Int. Cl.: H03K 17/24

(54) **NICHTFLÜCHTIGER 1-BIT ZUSTANDSSPEICHER UND BISTABILES SOLID-STATE-RELAIS UMFASSEND EINEN SOLCHEN**

(30) Priorität: 10.08.2023 DE 102023121434
(71) Anmelder: Liebherr-Electronics and Drives GmbH, 88131 Lindau (DE)
(72) Erfinder: HUMMEL, Lars, 88239 Wangen (DE); TRÖBERSBERGER, Andreas, 88175 Scheidegg (DE); ROSE, Michael, 88161 Lindenberg i.A. (DE); FINK, Cornelius, 6932 Langen bei Bregenz (AT)
(74) Vertreter: Thoma, Michael

(57) **Zusammenfassung**

Die vorliegende Erfindung betrifft einen nichtflüchtigen 1-Bit Zustandsspeicher (1), der einen ersten Signalwandler (digitales Potentiometer 2, mit nichtflüchtigem Multi-Bit Speicher 5) zum Wandeln eines digitalen Eingangssignals (15) in ein analoges Zwischensignal (bei 6) und einen zweiten Signalwandler (Schmitt Trigger 3) zum Wandeln des analogen Zwischensignals in ein digitales Ausgangssignal (11) umfasst, wobei der erste Signalwandler mit einem nichtflüchtigen Speicher (5, welcher nicht notwendiger Weise ein 1-Bit Zustandsspeicher ist, sondern auch ein Mehr-Bit Zustandsspeicher sein kann) versehen ist, damit nach einer Unterbrechung einer Versorgungsspannung wieder das zuvor ausgegebene analoge Zwischensignal herstellt wird und so auch der Ausgang des Schmitt Triggers das Ausgangs-Bit des 1-Bit Zustandsspeichers wieder hergestellt wird.

Der 1-Bit Zustandsspeicher kann auch bei einem bistabilen Solid-State Relay dafür sorgen, dass nach einer Unterbrechung der Versorgungsspannung der bistabile Schaltzustand des Solid-State Relays wiederhergestellt wird.

## Beschreibung

Die vorliegende Erfindung betrifft einen nichtflüchtigen 1-Bit Zustandsspeicher sowie ein bistabiles Solid-State-Relais mit einem solchen nichtflüchtigen 1-Bit Zustandsspeicher.

Nichtflüchtige 1-Bit Zustandsspeicher sind Bausteine in digitalen Systemen und werden für eine Vielzahl von Anwendungen benötigt. Der Vorteil eines nichtflüchtigen 1-Bit Zustandsspeichers ist, dass bei einer Unterbrechung der Versorgungsspannung der vormals eingenommene Ausgangszustand gespeichert ist und bei einer Wiederkehr der Versorgungsspannung wieder eingenommen werden kann.

Am Markt befindliche Umsetzungen eines solchen nichtflüchtigen 1-Bit Zustandsspeichers greifen hierbei auf komplexe Hardware zurück, die auf einen Mikrocontroller in Verbindung mit einem nichtflüchtigen Speicher, zum Beispiel EEPROM, basieren.

Eine weniger komplexe, jedoch für Luftfahrtanwendungen sehr teure und sehr fehleranfällige, Umsetzung aus dem Stand der Technik lehrt das magnetische Speichern des Zustands des 1-Bit Zustandsspeichers mithilfe von Dauermagneten (wie sie in bistabilen Mechanik-Relais Verwendung finden), sodass der vor einem Versorgungsspannungsausfall eingenommene Zustand bei Wiederkehr der Versorgungsspannung wieder eingenommen werden kann.

Vorliegend ist es das Ziel der Erfindung, einen nichtflüchtigen 1-Bit Zustandsspeicher vorzusehen, der mit einfachen handelsüblichen Bauteilen (COTS, englisch für: Commercial Off-The-Shelf) umgesetzt werden kann und nicht mit einem komplexen Bauteil wie z.B. Mikrocontroller (mit dazugehöriger aufwendiger Steuer-Software) zusammenwirken muss. Ein solcher 1-Bit Zustandsspeicher ist nicht nur billiger als herkömmliche Umsetzungen, sondern weist darüber hinaus auch noch eine bedeutend geringere Komplexität auf, was zu einer höheren Zuverlässigkeit führt.

Dieses Ziel wird durch einen nichtstabilen 1-Bit Zustandsspeicher erreicht, der sämtliche Merkmale des Anspruchs 1 aufweist. Darüber hinaus beansprucht die vorliegende Erfindung ein bistabiles Halbleiter-Relais, welches den nichtflüchtigen 1-Bit Zustandsspeicher umfasst. Ein Verfahren zum Betreiben des nichtflüchtigen 1-Bit Zustandsspeichers bzw. des nichtflüchtigen bistabilen Halbleiter-Relais ist ebenfalls angegeben.

Vorteilhafte Ausgestaltungen der vorliegenden Erfindung sind dabei in den abhängigen Ansprüchen niedergelegt.

Nach der Erfindung ist vorgesehen, dass der nichtflüchtige 1-Bit Zustandsspeicher, einen ersten Signalwandler, insbesondere ein D/A-Wandler, zum Wandeln eines digitalen Eingangssignals in ein analoges Ausgangssignal, und einen bistabilen Signalwandler, insbesondere eine bistabile Kippstufe, umfasst, dessen Eingang mit dem analogen Ausgangssignal des Signalwandlers verbunden ist, wobei der erste Signalwandler mit einem nichtflüchtigen Speicher versehen ist, damit nach einer Unterbrechung einer Versorgungsspannung wieder das zuvor ausgegebene analoge Ausgangssignal am Ausgang des Signalwandlers anliegt.

Durch die Verschaltung des ersten Signalwandlers mit dem bistabilen Signalwandler wird ein nichtflüchtiger 1-Bit Zustandsspeicher erreicht, der sich aus zwei Standardbauteilen der Elektronik ergibt.

Dabei wird zum Betrieb des 1-Bit Zustandsspeichers zunächst ein digitaler Signalwert an den ersten Signalwandler gegeben, der dort in einen entsprechenden Analogwert umgewandelt wird. Dieser Analogwert, in der Regel ein Widerstands-oder Spannungswert wird dann an den Eingang eines bistabilen Signalwandlers gegeben, sodass dieser an seinem Ausgang entweder eine logische 1 (bspw. Versorgungsspannung, Vcc) oder eine logische 0 (bspw. Masseniveau) ausgibt.

Da der erste Signalwandler über einen nichtflüchtigen Speicher verfügt, der bei einem Ausfall der Versorgungsspannung dafür sorgt, dass das vor dem Ausfall an ihn übermittelte (digitale) Eingangssignal abgespeichert ist, kann nach einer Rückkehr der Versorgungsspannung auf das dort abgespeicherte Eingangssignal zurückgegriffen werden, sodass der Zustand vor einem Ausfall der Versorgungsspannung wieder eingenommen werden kann.

Der Clou der vorliegenden Erfindung liegt nun hierbei, dass für das Erzeugen eines nichtflüchtigen 1-Bit Zustandsspeichers keine der am Markt komplexen Umsetzung mit einem Mikrocontroller oder mechanischen Umsetzung mit internen Dauermagneten verwendet werden muss, sondern zwei in der Elektronik weitverbreitete Bausteine miteinander kombiniert werden. Dabei scheint es zunächst widersprüchlich, ein digitales Signal, nämlich das an den ersten Signalwandler gegebene Eingangssignal in ein Analogsignal umzuwandeln, um es dann erneut in einen digitales Ausgangssignal (mithilfe des bistabilen Signalwandlers) umzuwandeln. Die Verbindung dieser beiden Bestandteile ist aber in seiner Funktion den deutlich komplexeren und teureren am Markt verfügbaren Lösungen ebenbürtig, dazu aber noch deutlich günstiger und zuverlässiger.

Nach einer optionalen Modifikation der vorliegenden Erfindung kann vorgesehen sein, dass der Signalwandler zum Wandeln eines digitalen Eingangssignals in ein analoges Ausgangssignal ein digitales Potentiometer ist.

Eine eher seltene Bezeichnung für ein digitales Potentiometer ist resistiver Digital-Analog-Konverter, was bereits auf die Fähigkeit des digitalen Potentiometers ein digitales Eingangssignal in ein analoges Ausgangssignal umzuwandeln, hinweist.

Ein digitales Potentiometer ist eine Art von elektronischem Gerät, das die gleiche grundlegende Funktion wie ein herkömmliches (analoges) Potentiometer erfüllt, aber digital gesteuert wird.

Ein analoges Potentiometer ist ein dreiterminaler Widerstand mit einem verschiebbaren oder drehbaren Kontakt, der den Teilungswert des Widerstands bestimmt. Durch Drehen oder Verschieben des Kontakts kann der Widerstand entlang des Potentiometers verändert werden, wodurch es zur Anpassung elektrischer Signale wie Lautstärke, Helligkeit und so weiter verwendet werden kann.

Ein digitales Potentiometer funktioniert ähnlich, aber anstelle eines mechanischen Elements zur Einstellung des Widerstandes verwendet es hierfür digitale Signale. Es hat typischerweise drei wichtige Anschlüsse: die beiden Enden des Widerstands (auch: Potentiometerendanschlüsse) und den beweglichen Kontakt (gewöhnlich als "Wiper" oder "Mittelabgriff" bezeichnet).

Das an den Signalwandler gegebene digitale Eingangssignal wird demnach mit dem digitalen Potentiometer derart verbunden, dass dieses die Bewegung des Mittelabgriffs steuert. Bei einer entsprechenden Verschaltung des digitalen Potentiometers als Spannungsteiler liegt dann in Abhängigkeit des digitalen Eingangssignals am Mittelabgriff eine dazu korrespondierende analoge Spannung an. Bei einem maximalen Wert des digitalen Eingangssignals ist der Mittelabgriff mit dem oberen Potentiometerendanschluss verbunden, so dass an dem Mittelabgriff die maximale analoge Spannung (bspw. Vcc des digitalen Potentiometers) anliegt. Im umgekehrten Fall, also wenn ein minimaler Wert des digitalen Eingangssignals an den Kanal zum Steuern des Mittelabgriffs des digitalen Potentiometers eingegeben wird, wird der Mittelabgriff entsprechend verschoben, so dass er mit dem unteren Potentiometerendanschluss verbunden ist. Dieser ist typischerweise mit Masse verbunden, sodass an dem Mittelabgriff minimale analoge Spannung anliegt. Es wird also das eingegebene digitale Signal in eine entsprechende analoge Spannung gewandelt.

Alternativ kann das Potentiometer als ein einzelner zweipoliger variabler Widerstand mit einem externen zusätzlichen Widerstand zu einem Spannungsteiler verschaltet werden wodurch wieder ein Potentiometer entsteht.

Alternativ zu einem Potentiometer, über dessen Widerstandsausgänge durch Anschließen einer Versorgungsspannung eine Ausgangsspannung anliegt, kann ein Signalwandler mit Spannungsausgang verwendet werden.

Sollte nun die Versorgungsspannung des Signalwandlers ausfallen, sorgt der nichtflüchtige Speicher des digitalen Potentiometers dafür, dass das letzte Eingangssignal, was vor einer Unterbrechung der Versorgungsspannung an den digitalen Potentiometer eingegeben wurde, abgespeichert ist, sodass dieses nach Rückkehr der Versorgungsspannung unverzüglich weiterverarbeitet werden kann, wodurch der zuletzt eingenommene Zustand vor dem Ausfall der Versorgungsspannung wieder erreicht wird.

Die Verwendung eines digitalen Potentiometers als erster Signalwandler ist insbesondere deswegen von Vorteil, da digitale Potentiometer mit einem nichtflüchtigen Speicher, der das zuletzt eingegebene digitale Stellsignal abspeichert, eine gute Marktverfügbarkeit haben und sich bereits über einen längeren Zeitraum bewährt haben.

Wie vorstehend bereits kurz erläutert, kann nach der vorliegenden Erfindung vorteilhafterweise vorgesehen sein, dass ein Mittelabgriff, also der variabel einstellbare Ausgang des digitalen Potentiometers, der Ausgang des ersten Signalwandlers ist.

Dabei ist es bei der Verwendung des digitalen Potentiometers als erster Signalwandler besonders vorteilhaft, wenn dieser - wie obenstehend beschrieben - als Spannungsteiler verschaltet ist. Dabei wird an dem oberen Potentiometerendanschluss eine höhere Spannung angelegt als gegenüber dem unteren Potentiometerendanschluss, sodass der Mittelabgriff je nach Stellung einen spezifischen Spannungswert besitzt. Von Vorteil kann dabei insbesondere sein, wenn an den oberen Potentiometerendanschluss bspw. eine Versorgungsspannung (Vcc) und an den unteren Potentiometerendanschluss Masse angeschlossen ist. Dem Fachmann ist aber bewusst, dass es für die Funktionalität des digitalen Potentiometers als ersten Spannungswandler tatsächlich nur auf eine Differenz im Spannungswert an den beiden Potentiometerendanschlüssen ankommt.

So kann es aber dennoch vermutlich als Regelfall betrachtet werden, dass - entsprechend einer vorteilhaften Modifikation der vorliegenden Erfindung - das digitale Potentiometer mit seinem oberen Potentiometerendanschluss an die Versorgungsspannung und/oder mit seinem unteren Potentiometerendanschluss an Masse angeschlossen ist. Dies einfach deswegen, da die Versorgungsspannung als "hohe" Spannung genau wie die Masse leicht verfügbar ist.

Nach einer optionalen Modifikation der vorliegenden Erfindung kann vorgesehen sein, dass der erste Signalwandler zum Wandeln eines digitalen Eingangssignals in ein analoges Ausgangssignal ein Digital-Analog-Konverter ist.

Zur Umsetzung der Grundidee der vorliegenden Erfindung ist es ausreichend, wenn das digitale Eingangssignal des ersten Signalwandlers an einen Digital-Analog-Konverter gegeben wird. Der Ausgang eines solchen Digital-Analog-Konverters nimmt dabei einen entsprechend zu dem digitalen Eingangssignal passenden analogen Spannungspegel an, sodass bei einem hohen Wert eines digitalen Eingangssignals eine hohe Spannung und bei einem niedrigen Wert des digitalen Eingangssignals eine niedrige Spannung ausgegeben wird.

Die Verwendung eines Digital-Analog-Konverters als erster Signalwandler ist deswegen von Vorteil, da diese Bauteile ebenfalls eine hohe Marktverfügbarkeit haben, und es auch günstige Umsetzungen gibt, die die geforderte Funktion des nichtflüchtigen Speichers aufweisen, damit nach einem Ausfall der Versorgungsspannung das zuletzt eingegebene digitale Eingangssignal unmittelbar nach Wiederkehr der Versorgungsspannung verarbeitet werden kann, so dass das vor dem Ausfall der Versorgungsspannung ausgegebene analoge Ausgangssignal erneut ausgegeben werden kann, ohne dass eine erneute Ansteuerung über das Eingangssignal erforderlich wäre.

Nach einer vorteilhaften Umsetzung der vorliegenden Erfindung kann vorgesehen sein, dass der Ausgang des bistabilen Signalwandlers den Zustand des nichtflüchtigen 1-Bit Zustandsspeichers ausgibt. Ein bistabiler Signalwandler, auch bekannt als bistabile Kippstufe oder Schwellwertschalter, ist eine Art von Schaltkreis, der zwei stabile Zustände hat. Er kann von einem Zustand in den anderen wechseln und in diesem Zustand verbleiben, bis das Eingangssignal ihn dazu veranlasst, den Zustand zu wechseln.

Der Eingang des bistabilen Signalwandlers ist nach der vorliegenden Erfindung dabei mit dem Ausgang des ersten Signalwandlers (bspw. umgesetzt durch das digitale Potentiometer oder den Digital-Analog-Konverter) verbunden, und bewirkt, dass der Ausgang des bistabilen Signalwandlers auf logisch 1 oder logisch 0 gesetzt wird. Welchen der beiden Zustände der bistabile Signalwandler ausgibt, hängt davon ab, ob das an den Eingang eingegebene analoge (Spannungs-) Signal oberhalb eines Schwellenwerts oder unterhalb dieses Schwellenwerts liegt. Für den Fachmann ist dabei klar, dass der logische Wert 0 bzw. der logische Wert 1 -je nach Verschaltung des bistabilen Signalwandlers - bspw. Masse bzw. Vcc entspricht.

Demnach kann nach der Erfindung vorgesehen sein, dass der bistabile Signalwandler dazu ausgelegt ist, bei einem Überschreiten eines Schwellenwerts eines am Eingang anliegenden Eingangssignals den Ausgang auf logisch 1 und bei einem Unterschreiten eines oder des Schwellenwerts des am Eingang anliegenden Eingangssignals den Ausgang auf logisch 0 zu setzen.

Vorteilhafterweise kann nach der Erfindung vorgesehen sein, dass der bistabile Signalwandler ein Schmitt-Trigger ist. Dieser sorgt für die Umwandlung eines sich ständig ändernden Eingangssignals in ein Ausgangssignal mit zwei festen Zuständen, nämlich "High" (Hoch) und "Low" (Niedrig).

Der entscheidende Vorteil eines Schmitt-Triggers liegt in seiner Hysterese. Die Hysterese bezieht sich auf die unterschiedlichen Schwellenwerte, die für den Wechsel zwischen den beiden Zuständen festgelegt sind. Wenn das Eingangssignal einen bestimmten hohen Schwellenwert (die sogenannte obere Schwelle) überschreitet, wechselt das Ausgangssignal auf logisch 1 (High). Es bleibt auf logisch 1, auch wenn das Eingangssignal unter diesen hohen Schwellenwert fällt, solange es nicht unter einen niedrigeren Schwellenwert (die sogenannte untere Schwelle) fällt. Erst dann wird als Ausgangssignal logisch zu von null (Low) ausgegeben. Dieser Mechanismus verhindert, dass schnelle oder unerwünschte Änderungen des Eingangssignals das Ausgangssignal flattern lassen.

Demnach kann nach der vorliegenden Erfindung vorteilhafter Weise vorgesehen sein, dass der Schmitt-Trigger für das Wechseln des Ausgangssignals auf logisch 1 einen ersten Schwellenwert und für das Wechseln des Ausgangssignals auf logisch 0 einen zum ersten Schwellenwert verschiedenen zweiten Schwellenwert aufweist, wobei der erste Schwellenwert von einer Mitte eines am Eingang des Schmitt-Triggers anlegbaren Spannungsbereichs nach oben und der zweite Schwellenwert von einer Mitte eines am Eingang des Schmitt-Triggers anlegbaren Spannungsbereichs nach unten beabstandet ist, vorzugsweise derart, dass ein beliebiger Wechsel eines beliebigen Bits durch einen Bitfehler im digitalen Eingangssignal des Signalwandlers oder des nichtflüchtigen Speichers nicht zu einem Wechsel des Ausgangssignals am Schmitt-Trigger führt.

Dabei kann vorgesehen sein, dass der obere Schwellenwert im oberen Drittel, vorzugsweise im oberen Viertel und der untere Schwellenwert im unteren Drittel, vorzugsweise im unteren Viertel des erfassbaren Spannungsbereich liegt.

Der obere Schwellenwert (erste Schwellenwert) und der untere Schwellenwert (zweite Schwellenwert) sind dabei so weit voneinander beabstandet, dass das zufällige und ungewollte "Kippen" eines einzelnen Bits im digitalen Eingangssignal des Signalwandlers nicht dazu führt, dass der Schmitt-Trigger seinen Ausgangszustand ändert, sofern ein entsprechend hoher digitale Eingangswert bzw. ein entsprechend niedriger digitale Eingangswert für den Signalwandler verwendet wird.

Dies ist insbesondere deswegen von Vorteil, da bei der Verwendung des nichtflüchtigen 1-Bit Zustandsspeichers im Luftfahrtbereich sogenannte Single-Event-Upsets auftreten können, die das zufällige "Kippen" eines Bits in einem Bitstream bewirken.

Ein Single-Event-Upset (SEU) ist ein Phänomen, das hauptsächlich in der Luft- und Raumfahrt auftritt, kann aber auch in anderen Hochleistungsumgebungen beobachtet werden. Es bezieht sich auf eine Veränderung des Zustands oder des Verhaltens eines elektronischen Bauteils oder Systems, die durch einen einzelnen, hochenergetischen Partikel hervorgerufen wird. Diese Partikel können aus der natürlichen Strahlungsumgebung stammen und treten insbesondere in großen Höhen oder im Weltraum auf, wo die Strahlungsniveaus höher sind als auf der Erdoberfläche.

Wenn ein solches Partikel auf einen Halbleiter in einem elektronischen Bauteil trifft, kann es genug Energie deponieren, um den Zustand eines Bit in einem Speicherbaustein zu ändern, ihn also zum Kippen bringen, was auch als Bit-Flip bezeichnet wird. Solche Bit-Flip-Ereignisse können zu Fehlern in der Datenverarbeitung führen, was potenziell gefährlich sein kann, insbesondere in sicherheitskritischen Systemen wie bei Luftfahrzeugen. Genau um diesen Effekt entgegenzuwirken, kann der Schmitt-Trigger zusammen mit dem Signalwandler so ausgelegt sein, dass das ungewollte Verändern eines einzelnen Bits im digitalen Eingangssignal des Signalwandlers nicht zu einem Wechsel des Ausgangszustands des Schmitt-Trigger führt.

Nach einer vorteilhaften Umsetzung der vorliegenden Erfindung kann vorgesehen sein, dass der Signalwandler und der bistabile Signalwandler jeweils durch einen separaten Logikbaustein, insbesondere durch eine integrierte Schaltung umgesetzt sind.

Das Verbinden dieser beiden separaten Bausteine bildet dann den beanspruchten nichtflüchtigen 1-Bit Zustandsspeicher, den es am Markt ansonsten nur in sehr komplexer Ausgestaltung oder zu sehr hohen Preisen gibt. Die vorliegende Erfindung umgeht diese Nachteile, indem sie diese Bauteile einfach miteinander kombiniert und erreicht somit eine vergleichbare Funktionalität bei deutlich weniger Kosten und besserer Robustheit.

Die Erfindung umfasst ferner ein bistabiles Solid-State-Relais, das einen nichtflüchtigen 1-Bit Zustandsspeicher nach einem der vorhergehenden Ansprüche, und ein Halbleiter-Relais umfasst, dessen Schalteingang zum Betätigen der Schaltfunktion des Relais mit dem Ausgang des bistabilen Signalwandlers verbunden ist.

Ein Solid-State-Relais (SSR), auch bekannt als Halbleiter-Relais, ist eine Art von Relais, das Halbleitertechnologie verwendet, um eine Schaltfunktion auszuführen. Im Gegensatz zu herkömmlichen elektromechanischen Relais, die eine mechanische Schaltaktion nutzen, basieren Solid-State-Relais auf Halbleiterbausteinen wie Transistoren, Thyristoren oder Triacs, um den Stromfluss zu steuern.

Ein typisches Solid-State-Relais hat vier Hauptanschlüsse: zwei für die Steuerspannung (Eingang) und zwei für die Last (Ausgang). Eine mögliche Umsetzung hierbei ist, dass der Eingang mit einer LED gekoppelt ist, die, wenn sie angesteuert wird, ein Lichtsignal erzeugt, das eine lichtempfindliche Halbleiterschaltung auf der Ausgangsseite des Relais aktiviert. Diese Schaltung öffnet oder schließt den Strompfad für die angeschlossene Last je nachdem, ob Licht von der LED abgestrahlt wird oder nicht.

Die Erfindung betrifft ferner ein Verfahren zum Betreiben eines nichtflüchtigen 1-Bit Zustandsspeichers nach einem der vorhergehend diskutierten Aspekte oder des vorstehend beschriebenen bistabilen Solid-State-Relais, wobei als Eingangssignal an den 1-Bit Zustandsspeicher ein Wert in der oberen Hälfte, vorzugsweise oberen Drittel, bevorzugterweise oberen Viertel, des vom Signalwandler entgegennehmbaren digitalen Eingangssignalbereichs zur Ausgabe einer logischen 1 am Ausgang 11 des bistabilen Multivibrators übermittelt wird oder als Eingangssignal an den 1-Bit Zustandsspeicher ein Wert in der unteren Hälfte vorzugsweise unteren Drittel, bevorzugterweise unteren Viertel, des vom Signalwandler entgegennehmbaren digitalen Eingangssignalbereichs zur Ausgabe einer logischen 0 am Ausgang 11 des bistabilen Multivibrators übermittelt wird.

Ferner kann nach einer vorteilhaften Modifikation des Verfahrens vorgesehen sein, dass bei der Umsetzung des bistabilen Multivibrators als Schmitt-Trigger der obere Schwellenwert und der untere Schwellenwert so voneinander beabstandet sind, dass bei einem ungewollten "Kippen" eines Bits im Eingangssignal des Signalwandlers das Ausgangssignal des Schmitt-Triggers nicht wechselt. So kann vorgesehen sein, dass der obere Schwellenwert im oberen Drittel, vorzugsweise oberen Viertel des gesamten Spannungsbereichs liegt, der von dem Schmitt-Trigger erfasst werden kann, und der untere Schwellenwert im unteren Drittel, vorzugsweise unteren Viertel des gesamten Spannungsbereichs liegt, der von dem Schmitt-Trigger erfasst werden kann. Bei entsprechender Wahl des digitalen Eingangssignals ist dann sogar eine 2-Bit Fehlertoleranz möglich, der das ungewollte Kippen von 2 Bits in dem digitalen Eingangssignal kompensiert werden kann.

Ferner kann nach einer optionalen Modifikation des Verfahrens vorgesehen sein, dass als Eingangssignal an den 1 -Bit Zustandsspeicher ein maximaler Wert des vom Signalwandler entgegennehmbaren digitalen Eingangssignalbereichs zur Ausgabe einer logischen 1 am Ausgang 11 des bistabilen Multivibrators übermittelt wird oder als Eingangssignal an den 1-Bit Zustandsspeicher ein minimaler Wert des vom Signalwandler entgegennehmbaren digitalen Eingangssignalbereichs zur Ausgabe einer logischen 0 am Ausgang 11 des bistabilen Signalwandlers übermittelt wird.

Hierdurch wird sichergestellt, dass im schlimmsten Fall ein Kippen von einem einzelnen Bit im Bitstream des digitalen Eingangssignals des Signalwandlers oder im Speicher des nichtflüchtigen Speichers nur dazu führt, dass das dann an den Signalwandler gegebene bzw. aus dem nichtflüchtigen Speicher weiter verarbeitete Signal ein Wert ist, der in etwa in der Mitte des digitalen Eingangssignalbereichs des Signalwandlers liegt.

Nimmt man bspw. an, dass das Eingangssignal 8 Bit umfasst, so reicht der Eingangssignalbereich von 0-255, da eine Bitfolge von [0000 0000] bis [1111 1111] möglich ist. Der Worst-Case für das Kippen eines einzelnen Bits ist dabei das Bit mit der höchsten Wertigkeit, auch genannt MSB (für Most Significant Bit).

Ist das tatsächlich im Speicher abgelegte oder über das Eingangssignal eingegebene Byte [0000 0000] und wird durch ein Single-Event-Upset in [1000 0000] ungewollt geändert, so entspricht dies einem Dezimalwert von 128. Umgekehrt gilt das der schlimmste Fall für eine Kippen eines Bits bei einem Byte [1111 1111] zur Sequenz [0111 111] wird, was einem Dezimalwert von 127 entspricht. Stellt man nun den Schmitt-Trigger entsprechend ein, dass dessen obere Schwelle oberhalb eines Spannungswerts liegt, der von dem Signalwandler ausgegeben wird, wenn dieser ein Eingangssignal in der Form [1000 0000] erhält, und dessen untere Schwelle unterhalb eines Spannungswerts liegt, der von dem Signalwandler ausgegeben wird, wenn dieser ein Eingangssignal in der Form [0111 1111] erhält, wird eine 1 Bit-Fehlertoleranz geschaffen, wenn man (im vorliegenden Beispiel) als Eingangssignal zum Ansteuern des nichtflüchtigen 1-Bit Zustandsspeichers entweder die Bitfolge [1111 1111] oder [0000 0000] verwendet.

Dem Fachmann ist bewusst, dass durch eine entsprechende größere Distanz der unteren Schwelle zu der oberen Schwelle des Schmitt-Trigger durchaus auch eine verbesserte Fehlertoleranz erreicht werden kann.

Die Erfindung betrifft ferner ein Fahrzeug, insbesondere ein Luftfahrzeug, mit einem nichtflüchtigen 1-Bit Zustandsspeicher nach einem der vorstehend beschriebenen Aspekte oder einem ebenfalls vorstehend beschriebenen bistabilen Solid-State-Relais.

Weitere Merkmale, Einzelheiten und Vorteile der Erfindung werden anhand der nachfolgenden Figurenbeschreibung ersichtlich. Dabei zeigen:
- Fig. 1:: eine schematische Darstellung einer Ausführungsform eines 1-Bit Zustandsspeichers, und
- Fig. 2:: eine schematische Darstellung einer Ausführungsform eines bistabilen Halbleiter-Relais mit einem 1-Bit Zustandsspeicher.

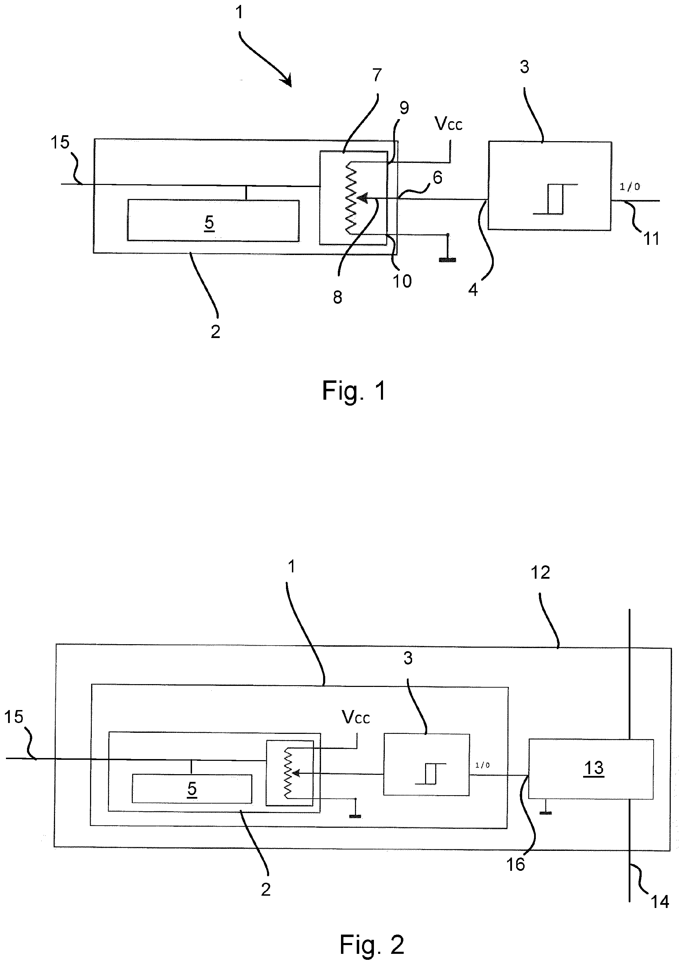

Fig. 1 zeigt eine schematische Darstellung einer Ausführungsform eines 1-Bit Zustandsspeichers 1. Man erkennt einen Signalwandler 2 zum Wandeln eines digitalen Eingangssignals in ein analoges Ausgangssignal, welches über einen digitalen Potentiometer 7 verfügt, der einen nichtflüchtigen Speicher 5 besitzt. Das digitale Potentiometer 7 verfügt dabei über einen Widerstand, der zwischen dem oberen Potentiometerendanschluss 9 und dem unteren Potentiometerendanschluss 10 angeordnet ist. Der Mittelabgriff 8 ist dabei verstellbar ausgebildet, sodass er je nach Steuersignal des digitalen Potentiometers 7 über den zwischen den beiden Potentiometerendanschlüssen angeordneten Widerstand bewegt wird. Die Stellung des Mittelabgriffs 8 wird dabei über die Eingangsleistung 15 definiert. Der nichtflüchtige Speicher 5 speichert dabei das über die Eingangsleistung 15 für die Bewegung des Mittelabgriffs ursächliche digitale Signal, sodass auch bei einem vorübergehenden Ausfall der Versorgungsspannung wieder unmittelbar derjenige Zustand eingenommen werden kann, der vor dem Ausfall der Versorgungsspannung eingestellt war.

In Fig. 1 ist dabei der obere Potentiometerendanschluss 9 mit der Versorgungsspannung und der untere Potentiometerendanschluss 10 mit Masse gekoppelt, sodass das digitale Potentiometer 7 als Spannungsteiler verschaltet ist. Je nach Stellung des Mittelabgriffs 8 liegt dabei am Ausgang 6 des Signalwandlers 2 eine zur Einstellung korrespondierende analoge Spannung an, die - wie bereits erläutert - durch das digitale Eingangssignal, welches über die Eingangsleistung 15 eingegeben wird, variiert werden kann.

Der Ausgang des Signalwandlers 6, wird mit dem Eingang 4 des bistabilen Signalwandlers 3 verbunden, sodass in Abhängigkeit des analogen Spannungswerts am Eingang des bistabilen Signalwandlers 3 entweder logisch 1 oder logisch 0 am Ausgang 11 des bistabilen Signalwandlers 3 ausgegeben wird. Hierbei kann ein einfacher Schwellenwertvergleich vorgenommen, der einen Abgleich des analogen Spannungswerts am Eingang 4 des bistabilen Signalwandlers 3 vornimmt, und in Abhängigkeit davon den Ausgang 11 des bistabilen Signalwandlers 3 ansteuert.

Bei Verwendung eines Schmitt-Triggers findet kein einfacher Schwellenwertvergleich des an den Schmitt-Trigger 3 eingegebenen analogen Spannungswerts statt, sondern es gibt eine obere Schwelle und eine untere Schwelle, wobei bei einem Überschreiten der oberen Schwelle auf logisch 1 und einem Unterschreiten der unteren Schwelle auf logisch 0 geschaltet wird. Dies ist insbesondere dann von Vorteil, wenn das Eingangssignal rauschbehaftet ist, da es bei dem Vorhandensein von nur einem Schwellenwert dann zu einem häufigen Wechsel des Ausgangssignals bei einem Kreuzen der Schwellenwerts kommen kann.

Fig. 1 zeigt demnach die Verwirklichung eines nichtflüchtigen 1-Bit Zustandsspeichers, der durch einfache Standardbauteile, sogenannten "Commercial-Off-The-Shelf"-Teilen, umgesetzt worden ist.

Der Speicherzustand "1" wird bspw. so eingestellt, indem das digitale Potentiometer auf seinen maximalen Wert gesetzt wird. Dies erfolgt dadurch, dass über den Eingangskanal 15 ein entsprechendes digitales Signal übermittelt wird. Dabei wird die gesamte Versorgungsspannung (zum Beispiel 3,3 V) an den bistabilen Signalwandler, insbesondere den Schmitt-Trigger 3, gelegt, welcher dadurch logisch 1 ausgibt. Der Speicherzustand "0" wird erreicht, indem das veränderbare digitale Potentiometer bspw. auf seinen minimalen Wert gesetzt wird. Dadurch wird die Masse (zum Beispiel 0 V) an den bistabilen Signalwandler 3, insbesondere den Schmitt-Trigger, gelegt, sodass dieser logisch 0 ausgibt.

Da die Position des Mittelabgreifers 8 im Potentiometer 7 durch den internen und nichtflüchtigen Speicher 5 abgespeichert ist, bleibt die Stellung des Mittelabgriffs 8 auch nach einer Unterbrechung der Versorgungsspannung auf dem vorher gespeicherten Wert. Zusammen mit dem bistabilen Signalwandler 3, der wie ein Digitalisierer wirkt, ist somit ein digitaler Wert, entweder 0 oder 1, gespeichert.

Fig. 2 zeigt eine Darstellung eines bistabilen Halbleiter-Relais 12, bei dem der in Fig. 1 dargestellte 1-Bit Zustandsspeicher 1 die Ansteuerung des Halbleiter-Relais 13 übernimmt.

Das Bezugszeichen 14 zeigt dabei die durch das Halbleiter-Relais 13 zu schaltende Leitung, die in Abhängigkeit des Eingangs 16 des Halbleiter-Relais 13 geschaltet wird. Dem Fachmann ist bewusst, dass es eine Vielzahl von möglichen Umsetzungen des Halbleiter-Relais 13 gibt, sodass auf eine spezifische Festlegung hierauf verzichtet wird. Eine Möglichkeit ist jedoch das Verwenden einer LED, die mit dem Eingang 16 des Halbleiter-Relais 13 verbunden ist und bei einem Pegel von logisch 1 Licht aussendet. Dabei verbindet das Relais 13 dann die Leitung 14, wenn Licht von der LED ausgesendet wird, wobei dies in der Regel über lichtsensitive Transistoren passiert.

Fig. 2 zeigt daher ein in seiner Struktur sehr einfaches und dennoch durch bekannte Bauteile erzeugtes bistabiles Solid-State-Relais 12, das gegenüber den herkömmlichen Umsetzungen deutlich günstiger und einfacher im Aufbau ist. So verwendet es weder einen Mikroprozessor noch interne Dauermagnete.

### Bezugszeichenliste:

- 1: 1-Bit Zustandsspeicher
- 2: Signalwandler (digitales Potentiometer mit internem nichtflüchtigem Speicher)
- 3: bistabiler Signalwandler
- 4: Eingang des bistabilen Signalwandler
- 5: nichtflüchtiger Speicher
- 6: Ausgang des Signalwandlers
- 7: digitales Potentiometer (ohne internen nichtflüchtigen Speicher)
- 8: Mittelabgriff des digitalen Potentiometers
- 9: oberer Potentiometerendanschluss
- 10: unterer Potentiometerendanschluss
- 11: Ausgang des bistabilen Signalwandlers
- 12: bistabiles Solid-State-Relais
- 13: Halbleiter-Relais
- 14: durch das Relais schaltbare Leitung
- 15: Eingangsleitung zum 1-Bit Zustandsspeicher
- 16: Eingang des Halbleiter-Relais

## Patentansprüche

1. Nichtflüchtiger 1-Bit Zustandsspeicher (1), umfassend:
einen Signalwandler (2), insbesondere ein D/A-Wandler, zum Wandeln eines digitalen Eingangssignals in ein analoges Ausgangssignal, und
einen bistabilen Signalwandler (3), insbesondere eine bistabile Kippstufe, dessen Eingang (4) mit dem analogen Ausgangssignal des Signalwandlers (2) verbunden ist, wobei
der Signalwandler (2) mit einem nichtflüchtigen Speicher (5) versehen ist, damit nach einer Unterbrechung einer Versorgungsspannung wieder das zuvor ausgegebene analoge Ausgangssignal am Ausgang (6) des Signalwandlers (2) anliegt.

2. Nichtflüchtiger 1-Bit Zustandsspeicher (1) nach dem vorhergehenden Anspruch 1, wobei der Signalwandler (2) zum Wandeln eines digitalen Eingangssignals in ein analoges Ausgangssignal ein digitales Potentiometer (7) ist.

3. Nichtflüchtiger 1-Bit Zustandsspeicher (1) nach dem vorhergehenden Anspruch 2, wobei ein Mittelabgriff (8), also der variabel einstellbare Ausgang des digitalen Potentiometers (7), der Ausgang (6) des Signalwandlers (2) ist.

4. Nichtflüchtiger 1-Bit Zustandsspeicher (1) nach einem der vorhergehenden Ansprüche 2 oder 3, wobei das digitale Potentiometer (7) als Spannungsteiler verschaltet ist.

5. Nichtflüchtiger 1-Bit Zustandsspeicher (1) nach einem der vorhergehenden Ansprüche 2 bis 4, wobei das digitale Potentiometer (7) mit seinem oberen Potentiometerendanschluss (9) an die Versorgungsspannung und/oder mit seinem unteren Potentiometerendanschluss (10) an Masse angeschlossen ist.

6. Nichtflüchtiger 1-Bit Zustandsspeicher (1) nach dem vorhergehenden Anspruch 1, wobei der Signalwandler (2) zum Wandeln eines digitalen Eingangssignals in ein analoges Ausgangssignal ein Digital-Analog-Konverter ist.

7. Nichtflüchtiger 1-Bit Zustandsspeicher (1) nach einem der vorhergehenden Ansprüche, wobei der Ausgang (11) des bistabilen Signalwandlers (3) den Zustand des nichtflüchtigen 1-Bit Zustandsspeichers (1) ausgibt.

8. Nichtflüchtiger 1-Bit Zustandsspeicher (1) nach einem der vorhergehenden Ansprüche, wobei der bistabile Signalwandler (3) dazu ausgelegt ist, bei einem Überschreiten eines Schwellenwerts eines am Eingang (4) anliegenden Eingangssignals den Ausgang (11) auf logisch 1 und bei einem Unterschreiten eines oder des Schwellenwerts des am Eingang (4) anliegenden Eingangssignals den Ausgang (11) auf logisch 0 zu setzen.

9. Nichtflüchtiger 1-Bit Zustandsspeicher (1) nach einem der vorhergehenden Ansprüche, wobei der bistabile Signalwandler (3) ein Schmitt-Trigger ist.

10. Nichtflüchtiger 1-Bit Zustandsspeicher (1) nach einem der vorhergehenden Anspruch 9, wobei der Schmitt-Trigger für das Wechseln des Ausgangssignals auf logisch 1 einen ersten Schwellenwert und für das Wechseln des Ausgangssignals auf logisch 0 einen zum ersten Schwellenwert verschiedenen zweiten Schwellenwert aufweist, wobei der erste Schwellenwert von einer Mitte eines am Eingang des Schmitt-Triggers (3) anlegbaren Spannungsbereichs nach oben und der zweite Schwellenwert von einer Mitte eines am Eingang des Schmitt-Triggers anlegbaren Spannungsbereichs nach unten beabstandet ist, vorzugsweise derart, dass ein beliebiger Wechsel eines beliebigen Bits durch einen Bitfehler im digitalen Eingangssignal des Signalwandlers (2) oder des nichtflüchtigen Speichers (5) nicht zu einem Wechsel des Ausgangssignals am Schmitt-Trigger (3) führt.

11. Nichtflüchtiger 1-Bit Zustandsspeicher (1) nach einem der vorhergehenden Ansprüche, wobei der Signalwandler (2) und der bistabile Signalwandler (3) jeweils durch einen separaten Logikbaustein, insbesondere durch eine integrierte Schaltung umgesetzt sind.

12. Bistabiles Solid-State-Relais (12), umfassend:
einen nichtflüchtigen 1-Bit Zustandsspeicher (1) nach einem der vorhergehenden Ansprüche, und
ein Halbleiter-Relais (13), dessen Schalteingang (16) zum Betätigen der Schaltfunktion des Relais (13) mit dem Ausgang (11) des bistabilen Signalwandlers (3) verbunden ist.

13. Verfahren zum Betreiben eines nichtflüchtigen 1-Bit Zustandsspeichers (1) nach einem der vorhergehenden Ansprüche 1-11 oder eines bistabilen Solid-State-Relais (12) nach dem vorhergehenden Anspruch 12, wobei als Eingangssignal an den 1-Bit Zustandsspeicher ein Wert in der oberen Hälfte, vorzugsweise oberen Drittel, bevorzugterweise oberen Viertel, des vom Signalwandler entgegennehmbaren digitalen Eingangssignalbereichs zur Ausgabe einer logischen 1 am Ausgang 11 des bistabilen Multivibrators übermittelt wird oder als Eingangssignal an den 1-Bit Zustandsspeicher ein Wert in der unteren Hälfte vorzugsweise unteren Drittel, bevorzugterweise unteren Viertel, des vom Signalwandler entgegennehmbaren digitalen Eingangssignalbereichs zur Ausgabe einer logischen 0 am Ausgang 11 des bistabilen Multivibrators übermittelt wird.

14. Verfahren nach dem vorhergehenden Anspruch 13, wobei als Eingangssignal an den 1-Bit Zustandsspeicher ein maximaler Wert des vom Signalwandler entgegennehmbaren digitalen Eingangssignalbereichs zur Ausgabe einer logischen 1 am Ausgang 11 des bistabilen Multivibrators übermittelt wird oder als Eingangssignal an den 1-Bit Zustandsspeicher ein minimaler Wert des vom Signalwandler entgegennehmbaren digitalen Eingangssignalbereichs zur Ausgabe einer logischen 0 am Ausgang 11 des bistabilen Multivibrators übermittelt wird.

15. Fahrzeug, insbesondere Luftfahrzeug mit einem nichtflüchtigen 1-Bit Zustandsspeicher (1) nach einem der Ansprüche 1-11 oder bistabiles Solid-State-Relais (12) nach Anspruch 12.
